# EUROPEAN PATENT APPLICATION

(11) **EP 4 636 481 A2**
(43) Date of publication of application: **22.10.2025**
(21) Application number: 25170792.3
(22) Date of filing: 15.04.2025
(51) Int. Cl.: G03F 7/00, G03F 7/004, G03F 7/031, G03F 7/038, G03F 7/075

(54) **PHOTOSENSITIVE RESIN COMPOSITION, PHOTOSENSITIVE RESIN FILM, PHOTOSENSITIVE DRY FILM, PATTERNING PROCESS, DISPLAY, AND MICRO-LED DISPLAY**

(30) Priority: 19.04.2024 JP 2024067911
(71) Applicant: SHIN-ETSU CHEMICAL CO., LTD., Tokyo 1000005 (JP)
(72) Inventor: MARUYAMA, Hitoshi, Gunma (JP); KUMAZAWA, Kumiko, Gunma (JP)
(74) Representative: Schicker, Silvia

(57) **Abstract**

The present invention is a photosensitive resin composition containing: (A) an acrylic resin having a (meth)acryloyl group in a side chain; (B1) quantum dots; (B2) a thiol ligand coordinated to a surface of the component (B1), the thiol ligand having a polymer structure including at least one repeating unit selected from ethylene oxide and propylene oxide; (C) an oxime-based photo-radical generator; (D) a surfactant; and (E) a solvent. This can provide: a photosensitive resin composition capable of easily forming a film having high lithography resolution and favorable luminous properties; a photosensitive resin film and a photosensitive dry film obtained by using the photosensitive resin composition; patterning processes using these; and displays obtained by using the photosensitive resin composition.

## Description

### TECHNICAL FIELD

The present invention relates to: a photosensitive resin composition; a photosensitive resin film; a photosensitive dry film; a patterning process; a display; and a micro-LED display.

### BACKGROUND ART

Various methods have been proposed to form displays containing red, green, and blue subpixels. As one of the methods, there is a method in which light from an LED array is converted through a color conversion structure such that blue light, having a shorter wavelength, is converted to red and green light, having longer wavelengths. Quantum dots have been employed for this color conversion.

Recently, such LED arrays are fabricated in micro size, and micro-LED displays using these have drawn attention. Although a method of forming a color conversion structure on an LED array includes a lithography process using a photosensitive material (Patent Document 1), further miniaturization is demanded recently for adaptation to compact displays. In addition, there are high demands for luminous properties from the viewpoint of display clarity.

### CITATION LIST

### PATENT LITERATURE

Patent Document 1: JP 2021-089347 A

### SUMMARY OF INVENTION

### TECHNICAL PROBLEM

The present invention has been made in view of the above circumstances. An object of the present invention is to provide: a photosensitive resin composition capable of easily forming a film having high lithography resolution and favorable luminous properties; a photosensitive resin film and a photosensitive dry film obtained by using the photosensitive resin composition; patterning processes using these; and displays obtained by using the photosensitive resin composition.

### SOLUTION TO PROBLEM

To achieve the object, the present invention provides a photosensitive resin composition comprising:
(A) an acrylic resin having a (meth)acryloyl group in a side chain;
(B1) quantum dots;
(B2) a thiol ligand coordinated to a surface of the component (B1), the thiol ligand having a polymer structure including at least one repeating unit selected from ethylene oxide and propylene oxide;
(C) an oxime-based photo-radical generator;
(D) a surfactant; and
(E) a solvent.

Such a photosensitive resin composition is capable of easily forming a film having high lithography resolution and favorable luminous properties.

The component (A) is preferably an alkali-insoluble resin having a weight-average molecular weight Mw of 10,000 to 50,000, a double bond equivalent of ≤ 300 g/mol, and an acid value of ≤ 10 mg KOH/g.

When the acrylic resin (A) having a (meth)acryloyl group in a side chain has a weight-average molecular weight in the above-described range, film loss in exposed portions hardly occurs at the time of development, and the solubility of unexposed portions is favorable.

It is preferable that the component (B1) has a core-shell structure including a core and a shell covering the core, the core containing one or more compounds including a combination of two or more of In, P, Zn, Ga, Cd, Se, S, Te, Pb, Ag, Hg, N, As, and O, and the shell containing one or more compounds including a combination of two or more of In, P, Zn, Ga, Cd, Se, S, Te, Pb, Hg, N, As, O, Mn, and Sr.

As the quantum dots, such quantum dots can be suitably used.

The component (B1) is preferably contained in an amount of 10 to 50 mass% based on a non-volatile component of the photosensitive resin composition.

When the content percentage of the quantum dot particles is within this range, fine pattern formation is possible while favorable luminous properties are retained.

The component (B2) is preferably contained in an amount of 5 to 45 parts by mass based on 100 parts by mass of the component (B1).

When the contained amount of the thiol ligand is in the above-described range, it is possible to achieve good compatibility with the acrylic resin (A) having a (meth)acryloyl group in a side chain, and the generation of agglomerated products can be suppressed and a pattern having a favorable shape can be formed with high sensitivity.

The component (C) is preferably contained in an amount of 0.1 to 1.5 mass% based on a non-volatile component of the photosensitive resin composition.

When the content percentage of the oxime-based photo-radical generator is in the above-described range, fine pattern formation is possible while favorable luminous properties are retained.

The present invention also provides a photosensitive resin film comprising a dried product of the above-described photosensitive resin composition.

Using the inventive photosensitive resin film, a photosensitive dry film can be manufactured.

The present invention also provides a photosensitive dry film comprising: a support film; and the above-described photosensitive resin film on the support film.

The inventive photosensitive dry film is capable of easily forming a film having high lithography resolution and favorable luminous properties.

The present invention also provides a patterning process comprising the steps of:
(i) applying the above-described photosensitive resin composition onto a substrate to form a photosensitive resin film on the substrate;
(ii) exposing the photosensitive resin film to light; and
(iii) developing the exposed photosensitive resin film with a developer to dissolve and remove an unexposed portion for patterning.

Using the inventive photosensitive resin composition, a pattern having a desired shape can be formed.

In this event, it is preferable that post-baking is not performed after the step (ii).

In this manner, the quantum dots (B1) do not have unnecessary thermal history, and high luminous properties of a cured film can be achieved.

The present invention also provides a patterning process comprising the steps of:
(i') bonding the photosensitive resin film of the above-described photosensitive dry film to a substrate to form the photosensitive resin film on the substrate;
(ii') exposing the photosensitive resin film to light; and
(iii') developing the exposed photosensitive resin film with a developer to dissolve and remove an unexposed portion for patterning.

Using the inventive photosensitive dry film, a pattern having a desired shape can be formed.

In this event, it is preferable that post-baking is not performed after the step (ii').

In this manner, the quantum dots (B1) do not have unnecessary thermal history, and high luminous properties of a cured film can be achieved.

The present invention also provides a display comprising a pattern formed of a cured film of the above-described photosensitive resin composition.

The inventive photosensitive resin composition can be used particularly suitably for such a purpose.

The present invention also provides a display comprising, in a top portion of a blue LED, a pattern formed of a cured film of the above-described photosensitive resin composition, light color-converted by quantum dots being obtained from each subpixel.

The inventive photosensitive resin composition can be used particularly suitably for such a purpose.

The present invention also provides a micro-LED display comprising, in a top portion of a blue LED, a pattern formed of a cured film of the above-described photosensitive resin composition, the pattern formed of the cured film having a size of 0.01 mm² or less, and light color-converted by quantum dots being obtained from each subpixel.

The inventive photosensitive resin composition can be used particularly suitably for such a purpose.

### ADVANTAGEOUS EFFECTS OF INVENTION

A film or a dry film formed from the inventive photosensitive resin composition can easily form, according to the inventive patterning process, a pattern that is fine and is excellent in verticality. Furthermore, an obtained cured film has high lithography resolution and favorable luminous properties, and therefore, can be used suitably for displays such as a micro-LED display.

### DESCRIPTION OF EMBODIMENTS

As described above, there have been demands for the development of: a photosensitive resin composition capable of easily forming a film having high lithography resolution and favorable luminous properties; a photosensitive resin film and a photosensitive dry film obtained by using the photosensitive resin composition; patterning processes using these; and displays obtained by using the photosensitive resin composition.

The present inventors have earnestly studied to achieve the object and consequently found that the object can be achieved by a photosensitive resin composition containing certain components, and completed the present invention.

That is, the present invention is a photosensitive resin composition comprising:
(A) an acrylic resin having a (meth)acryloyl group in a side chain;
(B1) quantum dots;
(B2) a thiol ligand coordinated to a surface of the component (B1), the thiol ligand having a polymer structure including at least one repeating unit selected from ethylene oxide and propylene oxide;
(C) an oxime-based photo-radical generator;
(D) a surfactant; and
(E) a solvent.

Hereinafter, the present invention will be described in detail, but the present invention is not limited thereto.

### [Photosensitive Resin Composition]

The inventive photosensitive resin composition contains:
(A) an acrylic resin having a (meth)acryloyl group in a side chain;
(B1) quantum dots;
(B2) a thiol ligand coordinated to a surface of the component (B1), the thiol ligand having a polymer structure including at least one repeating unit selected from ethylene oxide and propylene oxide;
(C) an oxime-based photo-radical generator;
(D) a surfactant; and
(E) a solvent.

### [(A) Acrylic Resin Having (Meth)acryloyl Group in Side Chain]

The acrylic resin (a polymer of an acrylic acid ester or a methacrylic acid ester) (A) having a (meth)acryloyl group in a side chain used in the present invention is not particularly limited.

In the present invention, the acrylic resin (A) having a (meth)acryloyl group in a side chain preferably has a weight-average molecular weight Mw of 10,000 to 50,000, more preferably 15,000 to 40,000. When the acrylic resin (A) having a (meth)acryloyl group in a side chain has a weight-average molecular weight in the above ranges, film loss of exposed portions hardly occurs during development, and the solubility of unexposed portions in an organic solvent is favorable. The weight-average molecular weight is a value determined as a weight-average molecular weight (weight-average degree of polymerization) in terms of polystyrene measured by GPC (gel permeation chromatography) analysis using toluene as an eluent.

In the present invention, the acrylic resin (A) having a (meth)acryloyl group in a side chain preferably has a double bond equivalent of ≤ 300 g/mol, more preferably ≤ 280 g/mol. Note that a double bond equivalent is the weight of the resin per acrylic group. When the acrylic resin (A) having a (meth)acryloyl group in a side chain has a double bond equivalent in the above ranges, the crosslinking density is high, and it is possible to form a pattern having a favorable shape with high sensitivity after development. Furthermore, the polarity of the side chain is enhanced, and therefore, compatibility with the quantum dots (B1) to which the ligand (B2) is coordinated is improved, and the generation of agglomerated products can be suppressed.

In the present invention, the acrylic resin (A) having a (meth)acryloyl group in a side chain is preferably an alkali-insoluble resin having an acid value of ≤ 10 mg KOH/g. When the acrylic resin (A) is an alkali-insoluble resin having an acid value of ≤ 10 mg KOH/g, the stability of the quantum dots (B1), to which the ligand (B2) is coordinated, in the cured film can be improved. Furthermore, since hardly any acid groups are contained, post-baking for eliminating the acidic groups is not needed, and therefore, the quantum dots (B1) do not have unnecessary thermal history, and high luminous properties of the cured film can be achieved.

In the present invention, one kind of the acrylic resin (A) having a (meth)acryloyl group in a side chain may be used, or two or more kinds thereof may be used in combination. Furthermore, the acrylic resin (A) having a (meth)acryloyl group in a side chain is preferably contained in an amount of 10 to 85 mass% based on a non-volatile component of the photosensitive resin composition; further preferably 20 to 80 mass%.

Examples of the acrylic resin (A) having a (meth)acryloyl group in a side chain include "RA-3631P" (trade name) manufactured by Negami Chemical Industrial Co., Ltd. and "8KQ-7060" (trade name) of Taisei Fine Chemical Co., Ltd.

### (B1) Quantum Dots]

The quantum dots (B1) used in the present invention are fine semiconductor particles having a particle size of 1 nm or more and 100 nm or less, and are not particularly limited as long as, when the quantum dots are excited by receiving external energy, the quantum dots release energy (emit light) according to corresponding energy band gap by its nature (autonomously). Incidentally, the particle size of the quantum dots (B1) can be, for example, a value determined by dynamic light scattering by using ELSZ-2000ZS, manufactured by Otsuka Electronics Co., Ltd.

Quantum dots (B1) have high responsiveness, and light emitted from a light source can be utilized efficiently. In addition, the energy state of the quantum dots depends on their size, and therefore, the emission wavelength can be selected freely by changing the particle size. Furthermore, the emitted light has a narrow spectral bandwidth, and by combining lights having such a steep peak, the color gamut that can be displayed can be expanded in a display equipped with a blue LED including a cured film formed from a photosensitive resin composition. Therefore, quantum dots that can be converted to red light and green light are preferable.

The quantum dots (B1) used in the present invention preferably have a core-shell structure including a core and a shell covering the core, and it is preferable that the core contains one or more compounds including a combination of two or more of In, P, Zn, Ga, Cd, Se, S, Te, Pb, Ag, Hg, N, As, and O, and the shell contains one or more compounds including a combination of two or more of In, P, Zn, Ga, Cd, Se, S, Te, Pb, Hg, N, As, O, Mn, and Sr. Preferable examples of such combinations include fine particles in which the core is InP or AgGaSe, and the shell is ZnS, ZnSe, or ZnSeS. Preferable core-shell combinations include core/shell = InP/ZnS, InP/ZnSe, InP/ZnSeS, and AgGaSe/ZnS.

The quantum dots (B1) used in the present invention are preferably contained in an amount of 10 to 50 mass%, more preferably 15 to 45 mass%, and further preferably 20 to 40 mass% based on the non-volatile component of the photosensitive resin composition. When the content percentage of the quantum dot particles is within these ranges, fine patterning is possible while favorable luminous properties are retained.

### [(B2) Thiol Ligand]

The thiol ligand (B2) coordinated to the surfaces of the quantum dots used in the present invention is coordinated to the surface of the component (B1), and is not particularly limited as long as the thiol ligand has a polymer structure including at least one repeating unit selected from ethylene oxide and propylene oxide.

Examples of such thiol ligands include a compound represented by the following formula (B2ex). 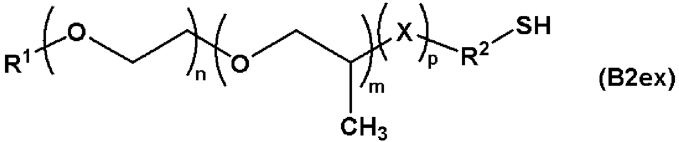 R¹ represents a hydrogen atom, a saturated hydrocarbyl group having 1 to 6 carbon atoms, an unsaturated hydrocarbyl group having 1 to 6 carbon atoms, or an aryl group having 6 to 12 carbon atoms, and "n" represents 0 to 100. R² represents a divalent saturated hydrocarbylene group having 1 to 6 carbon atoms and optionally containing a heteroatom, and "m" represents 0 to 100. Here, n + m > 0. X represents an ether, an ester, or an amide, and "p" represents 0 to 1. The unit shown by "m" and the unit shown by "n" may be arranged randomly or in blocks.

Specific examples of the compound represented by the formula (B2ex) include the following compounds.

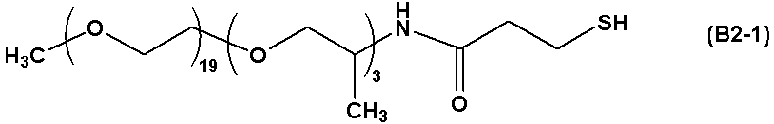

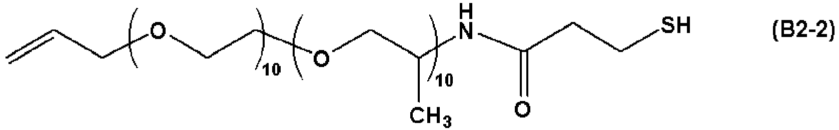

The polymer structure that such a thiol ligand has is not particularly limited as long as the polymer structure includes at least one repeating unit selected from ethylene oxide and propylene oxide, and examples include a homopolymer including ethylene oxide units, a homopolymer including propylene oxide units, a random copolymer including ethylene oxide units and propylene oxide units, and a block copolymer including ethylene oxide units and propylene oxide units.

The component (B2) thiol ligand can be, for example, synthesized by a method disclosed in JP 2020-523434 A. Regarding other matters concerning the component (B2) thiol ligand, JP 2020-523434 A may be consulted as necessary.

The thiol ligand (B2) used in the present invention is preferably contained in an amount of 5 to 45 parts by mass, more preferably 10 to 40 parts by mass, and further preferably 15 to 35 parts by mass based on 100 parts by mass of the component (B1) quantum dots. When the contained amount of the thiol ligand is in the above-described ranges, it is possible to achieve good compatibility with the acrylic resin (A) having a (meth)acryloyl group in a side chain, and the generation of agglomerated products can be suppressed and a pattern having a favorable shape can be formed with high sensitivity.

### [(C) Oxime-Based Photo-Radical Generator]

The oxime-based photo-radical generator used in the present invention is not particularly limited as long as it is an oxime compound for enhancing the sensitivity at the time of lithography.

Examples of the oxime compound include compounds of N-benzoyloxy-1-(4-phenylsulfanylphenyl)butan-1-one-2-imine, N-benzoyloxy-1-(4-phenylsulfanylphenyl)octan-1-one-2-imine, N-benzoyloxy-1-(4-phenylsulfanylphenyl)-3-cyclopentylpropan-1-one-2-imine, N-acetoxy-1-[9-ethyl-6-(2-methylbenzoyl)-9H-carbazol-3-yl]ethane-1-imine, N-acetoxy-1-[9-ethyl-6-{2-methyl-4-(3,3-dimethyl-2,4-dioxacyclopentanylmethyloxy)benzoyl}-9H-carbazol-3-yl]ethane-1-imine, N-acetoxy-1-[9-ethyl-6-(2-methylbenzoyl)-9H-carbazol-3-yl]-3-cyclopentylpropane-1-imine, and N-benzoyloxy-1-[9-ethyl-6-(2-methylbenzoyl)-9H-carbazol-3-yl]-3-cyclopentylpropan-1-one-2-imine. It is also possible to use commercially available products such as Irgacure OXE01 and OXE02 (manufactured by BASF Corporation) and ADEKA ARKLS NCI-930 and NCI-730 (manufactured by ADEKA CORPORATION) .

The oxime-based photo-radical generator (C) used in the present invention is preferably contained in an amount of 0.1 to 1.5 mass%, more preferably 0.2 to 1.3 mass% based on the non-volatile component of the photosensitive resin composition. When the content percentage of the oxime-based photo-radical generator is in the above-described ranges, fine pattern formation is possible while favorable luminous properties are retained.

### [(D) Surfactant]

The surfactant (D) used in the present invention is not particularly limited as long as it can enhance coating property, but is preferably a silicone-based surfactant.

Examples of silicone-based surfactants include surfactants having a siloxane bond in the molecule. Specific examples thereof include Toray Silicone DC3PA, SH7PA, DC11PA, SH21PA, SH28PA, SH29PA, SH30PA, SH8400 (trade names, manufactured by Dow Toray Co., Ltd.), KP321, KP322, KP323, KP324, KP326, KP340, KP341 (manufactured by Shin-Etsu Chemical Co., Ltd.), TSF400, TSF401, TSF410, TSF4300, TSF4440, TSF4445, TSF4446, TSF4452, and TSF4460 (manufactured by Momentive Performance Materials Japan LLC).

The surfactant (D) used in the present invention is preferably contained in an amount of 0.001 to 0.7 mass%, more preferably 0.005 to 0.5 mass% based on the non-volatile component of the photosensitive resin composition. When the content percentage of the surfactant is in the above-described ranges, it is possible to form a film that is highly flat.

### [(E) Solvent]

The solvent (E) used in the present invention is not particularly limited, as long as it can dissolve and disperse the above-described components (A) to (D) and other various additives if contained.

The solvent (E) is preferably an organic solvent. Examples thereof include ketones, such as cyclohexanone, cyclopentanone, and methyl-2-n-pentyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol-mono-tert-butyl ether acetate, and γ-butyrolactone; etc. One of these may be used, or two or more thereof may be used in mixture.

The solvent (E) is particularly preferably propylene glycol monomethyl ether acetate, propylene glycol monomethyl ether, cyclopentanone, or a mixed solvent thereof because of excellent dispersion for the quantum dots (B1), to which the thiol ligand (B2) is coordinated, and excellent solubility for the acrylic resin (A) having a (meth)acryloyl group in a side chain.

The component (E) is preferably contained in an amount of 25 to 85 mass%, more preferably 35 to 75 mass% based on the total amount of the photosensitive resin composition from the viewpoints of compatibility and viscosity of the photosensitive resin composition.

### [Other Additives]

The inventive photosensitive resin composition may contain other additives, besides the above-described components. Examples of other additives include a photopolymerizable compound, such as a polyfunctional (meth) acrylate, for the purpose of enhancing crosslinking density to form a pattern having a favorable shape after development, etc.

### [Silane Coupling Agent]

The inventive photosensitive resin composition preferably does not contain a silane coupling agent, although there is not particular limitation thereto. When no silane coupling agent is contained, it is possible further to reduce the risk that the viscosity of the photosensitive resin composition increases over time and storage stability becomes degraded. The cause of the increase in viscosity over time is not fully understood, but is thought to be likely to be the hydroxy groups in the side chains of the acrylic resin being crosslinked to each other in the side chains.

### [Photosensitive Resin Film]

The inventive photosensitive resin film is a dried product of the above-described photosensitive resin composition.

### [Patterning Process Using Photosensitive Resin Composition]

A patterning process using the inventive photosensitive resin composition includes the steps of:
(i) applying the photosensitive resin composition onto a substrate to form a photosensitive resin film on the substrate;
(ii) exposing the photosensitive resin film to light; and
(iii) developing the exposed photosensitive resin film with a developer to dissolve and remove an unexposed portion for patterning.

Furthermore, it is preferable that post-baking is not performed after the step (ii).

The step (i) is a step in which the photosensitive resin composition is applied onto a substrate to form a photosensitive resin film on the substrate. The photosensitive resin film is a dried product of the above-described photosensitive resin composition. Examples of the substrate include silicon wafers, glass wafers, quartz wafers, plastic circuit substrates, ceramic circuit substrates, etc.

The application method can be a known method. Examples thereof include a dipping method, a spin coating method, a roll coating method, etc. The application amount can be appropriately selected in accordance with the purpose. The application is preferably performed to obtain the photosensitive resin film (dried product of the photosensitive resin composition) with a thickness of preferably 0.1 to 50 µm, more preferably 1 to 30 µm.

In this case, the solvent or the like may be preliminary evaporated by pre-heating (pre-baking) as necessary for efficient photo-curing reaction. The pre-baking can be performed, for example, at 60 to 120°C for about 1 minute to 1 hour.

Then, in the step (ii), the photosensitive resin film is exposed to light. In this event, the exposure is preferably performed with light having a wavelength of 10 to 600 nm, more preferably performed with light having a wavelength of 190 to 500 nm. The light having such wavelengths are, for example, light having various wavelengths generated from a radiation-beam generating instrument. Examples of the light include ultraviolet light, such as a g-line, an h-line, and an i-line; far ultraviolet light (248 nm, 193 nm); etc. Among these, light with a wavelength of 248 to 436 nm is particularly preferable. The exposure dose is preferably 10 to 10,000 mJ/cm².

The exposure may be performed via a photomask. The photomask may have a desired pattern by boring, for example. Note that the material of the photomask is not particularly limited, but is preferably one that blocks light with the aforementioned wavelength. For example, a photomask including a light-blocking film made of chromium is suitably used, but is not limited thereto.

Then, in the step (iii), after the exposure, development is performed with a developer to form a pattern. Preferable examples of the developer include organic solvents such as: alcohols, such as IPA; ketones, such as cyclohexanone; glycols, such as propylene glycol monomethyl ether; etc. Examples of the development method include usual methods, for example, a dipping method in which the patterned substrate is soaked into the developer; a puddle method in which the developer is dispensed by puddle; and a spraying method in which the developer is applied by spraying. By performing the development in this manner, the unexposed portion is dissolved and removed, so that a pattern is formed. Then, if necessary, washing, rinsing, drying, and so forth are carried out to give a cured film having a desired pattern.

### [Photosensitive Dry Film]

The inventive photosensitive dry film includes: a support film; and a photosensitive resin film formed on the support film, the photosensitive resin film being obtained from the photosensitive resin composition.

The photosensitive dry film (a support film and a photosensitive resin film) is solid, and the photosensitive resin film does not contain a solvent. Accordingly, bubbles due to the volatilization of the solvent will not remain in the photosensitive resin film and between this film and an uneven substrate. The thickness of the photosensitive resin film is not particularly limited, but is preferably 1 to 100 µm, more preferably 3 to 50 µm.

In addition, at a high temperature, the viscosity and fluidity of the photosensitive resin film are closely related. The photosensitive resin film can exhibit appropriate fluidity in an appropriate viscosity range; the photosensitive resin film deeply enters into a narrow gap and the resin softens, so that the adhesion to a substrate can be enhanced. Thus, the viscosity of the photosensitive resin film at a high temperature is preferably 10 to 5,000 Pa·s, more preferably 30 to 2,000 Pa·s at 80°C from the viewpoint of the fluidity of the photosensitive resin film. Note that, in the present invention, the viscosity is a value measured with a rotational viscometer.

When the inventive photosensitive dry film is brought into close contact with an uneven substrate, the photosensitive resin film fits in and covers the unevenness, so that high flatness can be achieved. Particularly, the inventive photosensitive resin composition has softening performance, so that higher planarization can be achieved. Further, bringing the photosensitive resin film into close contact with the substrate under vacuum environment makes it possible to more effectively prevent a gap therebetween.

The inventive photosensitive dry film can be produced by applying the photosensitive resin composition onto a support film, and drying the composition to form a photosensitive resin film. As the production apparatus for the photosensitive dry film, it is possible to employ a film coater which is commonly used to produce adhesive products. Examples of the film coater include a comma coater, a comma reverse coater, a multi coater, a die coater, a lip coater, a lip reverse coater, a direct gravure coater, an offset gravure coater, a 3-roll bottom reverse coater, a 4-roll bottom reverse coater, etc.

When the support film is rolled-out from a roll-out shaft of the film coater and passes through a coater head of the film coater, the photosensitive resin composition is applied to have a predetermined thickness onto the support film; then, the resultant is passed through a hot-air circulating oven at a predetermined temperature for a predetermined period to dry and form the photosensitive resin film on the support film, so that the photosensitive dry film can be produced. It is also possible to produce the photosensitive dry film having a protective film in accordance with need by: passing the photosensitive dry film through a laminate roll under a predetermined pressure together with the protective film that has been rolled-out from another roll-out shaft of the film coater, thereby bonding the protective film to the photosensitive resin film on the support film; and subsequently winding up the resulting laminate to a winding shaft of the film coater. In this case, the temperature is preferably 50 to 120°C, the period is preferably 1 to 100 minutes, and the pressure is preferably 0.01 to 5 MPa.

The support film used in the inventive photosensitive dry film may be a monolayer film composed of a single film or a multilayer film composed of multiple laminated films. Examples of the material of the film include synthetic resin films, such as polyethylene, polypropylene, polycarbonate, and polyethylene terephthalate. Among these, preferable is polyethylene terephthalate having appropriate flexibility, mechanical strength, and heat resistance. These films may have been subjected to various treatments, such as corona treatment and coating treatment with a releasing agent. Commercial products may be used for these. Examples thereof include Cerapeel WZ (RX) and Cerapeel BX8 (R) (both are manufactured by Toray Advanced Film Co., Ltd.), E7302 and E7304 (both are manufactured by Toyobo Co., Ltd.), Purex G31 and Purex G71T1 (both are manufactured by Teijin DuPont Films Japan Ltd.), PET38×1-A3, PET38×1-V8, and PET38×1-X08 (all manufactured by Nippa Co., Ltd.), etc.

The protective film to be used may be the same film as the above-mentioned support film, but polyethylene terephthalate and polyethylene having appropriate flexibility are preferred. Commercial products may be used for these. Examples thereof include the polyethylene terephthalates that have already been exemplified; polyethylenes, such as GF-8 (manufactured by Tamapoly Co., Ltd.) and PE Film 0-Type (manufactured by Nippa Co., Ltd.); etc.

The thicknesses of both the support film and the protective film are preferably 10 to 100 µm, more preferably 25 to 50 µm, from the viewpoints of stable production of the photosensitive dry film and the rolling habit around a roll shaft, what is called curl-prevention.

### [Patterning Process using Photosensitive Dry Film]

A patterning process using the inventive photosensitive dry film includes the steps of:
(i') bonding the photosensitive resin film of the photosensitive dry film to a substrate to form the photosensitive resin film on the substrate;
(ii') exposing the photosensitive resin film to light; and
(iii') developing the exposed photosensitive resin film with a developer to dissolve and remove an unexposed portion for patterning.

Furthermore, it is preferable that post-baking is not performed after the step (ii').

First, in the step (i'), the photosensitive dry film is used to bond the photosensitive resin film to a substrate to form the photosensitive resin film on the substrate. Specifically, the photosensitive resin film of the photosensitive dry film is bonded to a substrate, so that the photosensitive resin film is formed on the substrate. Meanwhile, in the case where the photosensitive dry film has a protective film, after the protective film is peeled from the photosensitive dry film, the photosensitive resin film of the photosensitive dry film is bonded to the substrate. The bonding can be performed, for example, by using a film-bonding apparatus.

The film-bonding apparatus is preferably a vacuum laminator. For example, the protective film of the photosensitive dry film is delaminated, and the uncovered photosensitive resin film is brought into close contact with the substrate on a table at a predetermined temperature by using a bonding roll under a predetermined pressure in a vacuum chamber with a predetermined degree of vacuum. It is to be noted that the temperature is preferably 60 to 120°C, the pressure is preferably 0 to 5.0 MPa, and the degree of vacuum is preferably 50 to 500 Pa.

For efficient photo-curing reaction of the photosensitive resin film and for adhesiveness enhancement between the photosensitive resin film and the substrate, pre-baking may be performed as necessary. The pre-baking can be performed, for example, at 60 to 120°C for about 1 minute to 1 hour.

The photosensitive resin film adhered on the substrate can be subjected to (ii') the step of exposing the photosensitive resin film to light, and (iii') the step of developing the exposed photosensitive resin film with a developer to dissolve and remove an unexposed portion for patterning to form a pattern as in the case of the patterning process using the photosensitive resin composition. Note that the support film of the photosensitive dry film is delaminated before the development step, depending on the process.

The patterning processes using the inventive photosensitive resin composition or dry film make it possible to easily form fine patterns. For example, it is possible to form a film of the inventive photosensitive resin composition to cover numerous blue micro-LEDs laid over a substrate, followed by fine pattern formation such that the cured film including the quantum dots of red, green, etc. is formed at corresponding sections on the blue micro-LEDs. This enables light emission of red, green, etc. Thus, it is possible to produce a full-color display. This case is also applicable to mini-LEDs.

### [Display]

The present invention also provides a display including a pattern formed of a cured film of the inventive photosensitive resin composition. A pattern formed of a cured film of the inventive photosensitive resin composition can be obtained by the above-described patterning processes.

The inventive display can also be a display including, in a top portion of a blue LED, a pattern formed of a cured film of the inventive photosensitive resin composition, light color-converted by quantum dots being obtained from each subpixel.

### [Micro-LED Display]

The present invention also provides a micro-LED display including, in a top portion of a blue LED, a pattern formed of a cured film of the inventive photosensitive resin composition, the pattern formed of the cured film having a size of 0.01 mm² or less, and light color-converted by quantum dots being obtained from each subpixel.

### EXAMPLES

Hereinafter, the present invention will be specifically described with reference to Examples and Comparative Examples. However, the present invention is not limited to the Examples.

### [1] Preparation of Photosensitive Resin Composition and Evaluation Thereof

### [Examples R1 to 7 and G1 to 7 and Comparative Examples R1 to 14 and G1 to 14]

Each component was blended according to the formulation amount shown in Tables 1 to 6, then, the components were stirred and mixed at normal temperature, and micro-filtering was performed with a 1.0-µm glass filter to obtain photosensitive resin compositions (solutions in PGMEA) of Examples R1 to 7 and G1 to 7 and Comparative Examples R1 to 14 and G1 to 14. Note that, in the tables, the amounts are shown in such a manner that the total amount of the solid contents (components other than the solvent (E)) is 100.

**[Table 1]**

| Component | | | Example | | | | | | |
|---|---|---|---|---|---|---|---|---|---|
| | | | R1 | R2 | R3 | R4 | R5 | R6 | R7 |
| A | Resin | A-1 | 76.7 | 72.7 | | | 52.7 | | 48.5 |
| | | A-2 | | | 64.8 | 58.8 | | 44.7 | |
| | | A' -1 | | | | | | | |
| B1 | Quantum dots | B1R-1 | 20 | | 30 | | 40 | | 40 |
| | | B1R-2 | | 20 | | 30 | | 40 | |
| B2 | Ligand | B2-1 | 3 | | | 10.5 | 6 | | 10 |
| | | B2-2 | | 7 | 4.5 | | | 14 | |
| | | B2'-1 | | | | | | | |
| | | B2'-2 | | | | | | | |
| C | Photo-radical generator | C-1 | 0.2 | | 0.5 | | | 1 | 1.3 |
| | | C-2 | | 0.2 | | 0.5 | 1 | | |
| | | C'-1 | | | | | | | |
| | | C'-2 | | | | | | | |
| | | C'-3 | | | | | | | |
| D | Surfactant | D-1 | 0.1 | 0.1 | 0.2 | 0.2 | 0.3 | 0.3 | 0.2 |
| E | Solvent | PGMEA | 150 | 150 | 100 | 100 | 67 | 67 | 67 |

**[Table 2]**

| Component | | | Comparative Example | | | | | | | |
|---|---|---|---|---|---|---|---|---|---|---|
| | | | R1 | R2 | R3 | R4 | R5 | R6 | R7 | R8 |
| A | Resin | A-1 | 76.7 | | 76.7 | | 76.7 | | | |
| | | A-2 | | 44.7 | | 44.7 | | | | |
| | | A'-1 | | | | | | 44.7 | 76.7 | 44.7 |
| B1 | Quantum dots | B1R-1 | 20 | | 20 | | 20 | | 20 | |
| | | B1R-2 | | 40 | | 40 | | 40 | | 40 |
| B2 | Ligand | B2-1 | | | 3 | | 3 | | | |
| | | B2-2 | | | | 14 | | 14 | | |
| | | B2' -1 | 3 | | | | | | 3 | |
| | | B2' -2 | | 14 | | | | | | 14 |
| C | Photo-radical generator | C-1 | 0.2 | 1 | | | | 1 | | |
| | | C-2 | | | | | | | | |
| | | C'-1 | | | 0.2 | | | | 0.2 | |
| | | C'-2 | | | | 1 | | | | 1 |
| | | C'-3 | | | | | 0.2 | | | |
| D | Surfactant | D-1 | 0.1 | 0.3 | 0.1 | 0.3 | 0.1 | 0.3 | 0.1 | 0.3 |
| E | Solvent | PGMEA | 150 | 67 | 150 | 67 | 150 | 67 | 150 | 67 |

**[Table 3]**

| Component | | | Comparative Example | | | | | |
|---|---|---|---|---|---|---|---|---|
| | | | R9 | R10 | R11 | R12 | R13 | R14 |
| A | Resin | A'-2 | 76.0 | 45.6 | 43.5 | 26.1 | 76.0 | 43.5 |
| B1 | Quantum dots | B1R-1 | 20 | 20 | | | 20 | |
| | | B1R-2 | | | 40 | 40 | | 40 |
| B2 | Ligand | B2-1 | 3 | 3 | | | | |
| | | B2-2 | | | 14 | 14 | | |
| | | B2' -1 | | | | | 3 | |
| | | B2' -2 | | | | | | 14 |
| F | Photo-acid generator | F-1 | 1 | 1 | 2.5 | 2.5 | 1 | 2.5 |
| G | Epoxy crosslinking agent | G-1 | | 30.4 | | 17.4 | | |
| E | Solvent | PGMEA | 150 | 150 | 67 | 67 | 150 | 67 |

**[Table 4]**

| Component | | | Example | | | | | | |
|---|---|---|---|---|---|---|---|---|---|
| | | | G1 | G2 | G3 | G4 | G5 | G6 | G7 |
| A | Resin | A-1 | 76.7 | 72.7 | | | 52.7 | | 48.5 |
| | | A-2 | | | 64.8 | 58.8 | | 44.7 | |
| | | A' -1 | | | | | | | |
| B1 | Quantum dots | B1G-1 | 20 | | 30 | | 40 | | 40 |
| | | B1G-2 | | 20 | | 30 | | 40 | |
| B2 | Ligand | B2-1 | 3 | | | 10.5 | 6 | | 10 |
| | | B2-2 | | 7 | 4.5 | | | 14 | |
| | | B2' -1 | | | | | | | |
| | | B2' -2 | | | | | | | |
| C | Photo-radical generator | C-1 | 0.2 | | 0.5 | | | 1 | 1.3 |
| | | C-2 | | 0.2 | | 0.5 | 1 | | |
| | | C'-1 | | | | | | | |
| | | C'-2 | | | | | | | |
| | | C'-3 | | | | | | | |
| D | Surfactant | D-1 | 0.1 | 0.1 | 0.2 | 0.2 | 0.3 | 0.3 | 0.2 |
| E | Solvent | PGMEA | 150 | 150 | 100 | 100 | 67 | 67 | 67 |

**[Table 5]**

| Component | | | Comparative Example | | | | | | | |
|---|---|---|---|---|---|---|---|---|---|---|
| | | | G1 | G2 | G3 | G4 | G5 | G6 | G7 | G8 |
| A | Resin | A-1 | 76.7 | | 76.7 | | 76.7 | | | |
| | | A-2 | | 44.7 | | 44.7 | | | | |
| | | A'-1 | | | | | | 44.7 | 76.7 | 44.7 |
| B1 | Quantum dots | B1G-1 | 20 | | 20 | | 20 | | 20 | |
| | | B1G-2 | | 40 | | 40 | | 40 | | 40 |
| B2 | Ligand | B2-1 | | | 3 | | 3 | | | |
| | | B2-2 | | | | 14 | | 14 | | |
| | | B2'-1 | 3 | | | | | | 3 | |
| | | B2'-2 | | 14 | | | | | | 14 |
| C | Photo-radical generator | C-1 | 0.2 | 1 | | | | 1 | | |
| | | C-2 | | | | | | | | |
| | | C'-1 | | | 0.2 | | | | 0.2 | |
| | | C'-2 | | | | 1 | | | | 1 |
| | | C'-3 | | | | | 0.2 | | | |
| D | Surfactant | D-1 | 0.1 | 0.3 | 0.1 | 0.3 | 0.1 | 0.3 | 0.1 | 0.3 |
| E | Solvent | PGMEA | 150 | 67 | 150 | 67 | 150 | 67 | 150 | 67 |

**[Table 6]**

| Component | | | Comparative Example | | | | | |
|---|---|---|---|---|---|---|---|---|
| | | | G9 | G10 | G11 | G12 | G13 | G14 |
| A | Resin | A'-2 | 76.0 | 45.6 | 43.5 | 26.1 | 76.0 | 43.5 |
| B1 | Quantum dots | B1G-1 | 20 | 20 | | | 20 | |
| | | B1G-2 | | | 40 | 40 | | 40 |
| B2 | Ligand | B2-1 | 3 | 3 | | | | |
| | | B2-2 | | | 14 | 14 | | |
| | | B2' -1 | | | | | 3 | |
| | | B2' -2 | | | | | | 14 |
| F | Photo-acid generator | F-1 | 1 | 1 | 2.5 | 2.5 | 1 | 2.5 |
| G | Epoxy crosslinking agent | G-1 | | 30.4 | | 17.4 | | |
| E | Solvent | PGMEA | 150 | 150 | 67 | 67 | 150 | 67 |

In Tables 1 to 6, A-1 is "RA-3631P" (trade name) (acrylic resin, Mw: 18,000, acid value: 5 mg KOH/g, double bond equivalent: 250 g/mol) manufactured by Negami Chemical Industrial Co., Ltd., A-2 is "8KQ-7060" (trade name) (acrylic resin, Mw: 33,000, acid value: 10 mg KOH/g, double bond equivalent: 260 g/mol) of Taisei Fine Chemical Co., Ltd., and A'-1 is "PH-9001" (trade name) (urethane resin, Mw: 20,000, acid value: 41 mg KOH/g, double bond equivalent: 890 g/mol) of Taisei Fine Chemical Co., Ltd. Mw is data measured by GPC.

In Tables 1 to 6, B1R-1 is core-shell type quantum dots (red luminescence) in which the maximum fluorescence wavelength is 629 nm and core/shell = InP/ZnSe, B1G-1 is core-shell type quantum dots (green luminescence) in which the maximum fluorescence wavelength is 521 nm and core/shell = InP/ZnSe, B1R-2 is core-shell type quantum dots (red luminescence) in which the maximum fluorescence wavelength is 631 nm and core/shell = AgGaSe/ZnS, and B1G-2 is core-shell type quantum dots (green luminescence) in which the maximum fluorescence wavelength is 530 nm and core/shell = AgGaSe/ZnS. Note that the particle size of the quantum dots is 5 to 10 nm for red and 3 to 5 nm for green.

In Tables 1 to 6, B2-1 and B2-2 are as follows, and were synthesized by a method disclosed in JP 2020-523434 A. B2'-1 is oleic acid and B2'-2 is dodecanethiol.

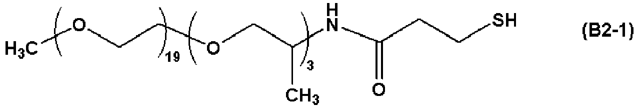

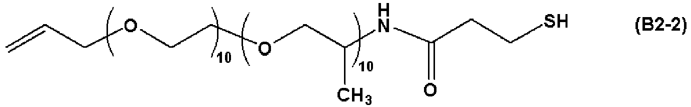

In Tables 1 to 6, C-1 is "Irgacure OXE01" (trade name) (oxime ester-based) manufactured by BASF Corporation, C-2 is "ADEKA ARKLS NCI-730" (trade name) (oxime ester-based) manufactured by ADEKA CORPORATION, C'-1 is "Irgacure 184" (trade name) (hydroxyalkylphenone-based) manufactured by BASF Corporation, C'-2 is "Irgacure 819" (trade name) (acyl phosphine oxide-based) manufactured by BASF Corporation, and C'-3 is "Irgacure 369" (trade name) (aminoalkylphenone-based) manufactured by BASF Corporation.

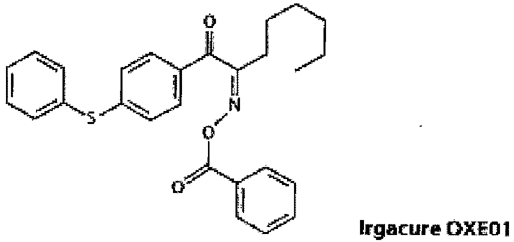

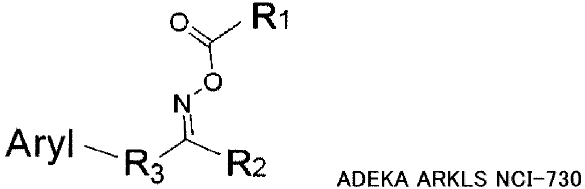

In Tables 1 to 6, D-1 is "KP341" (trade name) (polyether-type silicone-based surfactant) manufactured by Shin-Etsu Chemical Co., Ltd.

As A'-2 in Tables 1 to 6, a material synthesized in the following manner was used. Into a 3-L flask equipped with a stirrer, a thermometer, a nitrogen inflow instrument, and a reflux condenser, 265.0 g (1.00 mol) of the following Compound (S-5) was introduced. Then, 2,000 g of toluene was added thereto, and the mixture was heated to 70°C. Subsequently, 1.0 g of a solution of chloroplatinic acid in toluene (platinum concentration: 0.5 mass%) was introduced, and 164.9 g (0.85 mol) of the following Compound (S-1) and 453.0 g (0.15 mol) of the following Compound (S-2) (y¹=40, manufactured by Shin-Etsu Chemical Co., Ltd.) were added dropwise over 1 hour (total of hydrosilyl groups/total of alkenyl groups=1/1 (molar ratio)). After completion of the dropwise addition, the mixture was heated to 100°C and aged for 6 hours. Thereafter, toluene was evaporated from the reaction solution under reduced pressure. Thus, Resin A'-2 with an Mw of 65,000 was obtained.

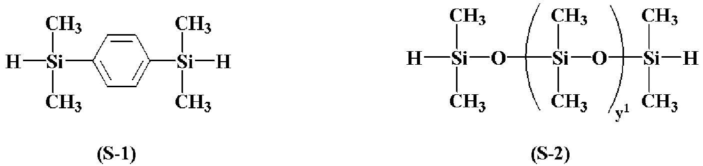

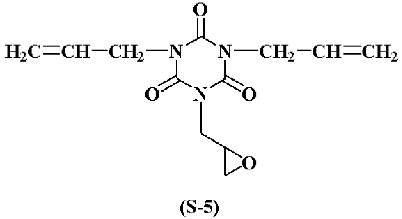

As the Photo-Acid Generator F-1 in Tables 1 to 6, "CPI-210S" (trade name) of San-Apro Ltd. was used.

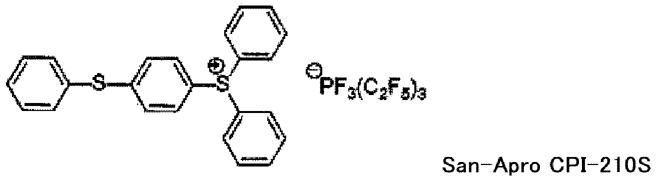

In Tables 1 to 6, the Epoxy Crosslinking Agent G-1 is as follows.

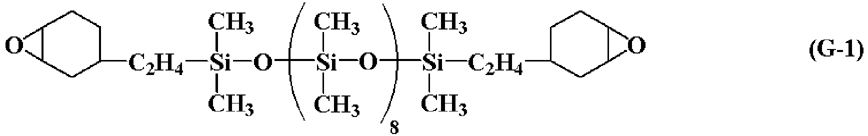

### [2] Preparation of Photosensitive Dry Films

Using a die coater as a film coater, the photosensitive resin compositions shown in Tables 1 to 6 were respectively applied onto support films which were polyethylene terephthalate films (thickness: 38 µm). Then, the resultant was dried by passing, for 5 minutes, through a hot-air circulating oven (length: 4 m) set at 80°C. Thereby, a photosensitive resin film was formed on the support film to have a thickness of 5 µm, and a photosensitive dry film was obtained. Onto the photosensitive resin film, a polyethylene film (thickness: 50 µm) as a protective film was bonded using a laminate roll at a pressure of 1 MPa. In this manner, photosensitive dry films with a protective film were prepared. The protective film of the prepared dry film was peeled. In this event, when it was visually observed that there was even one portion where the photosensitive resin film had adhered to the protective film and had been detached from the base material film, the evaluation "Bad" was given, and when no problems occurred, the evaluation "Good" was given. The results are shown in Tables 7 to 12.

### [3] Pattern Formation and Evaluation Thereof

The protective film was peeled from the photosensitive dry film with a protective film, and the photosensitive resin film on the support film was respectively brought into close contact with a silicon wafer by using a vacuum laminator TEAM-100RF (manufactured by Takatori Corporation) with the degree of vacuum in the vacuum chamber set to 80 Pa. The temperature condition was set to 100°C. The pressure was restored to normal pressure, then the substrate was taken out of the vacuum laminator, and the support film was peeled. Subsequently, to enhance the adhesion to the substrate, pre-baking was performed with a hot plate at 100°C for 2 minutes. Exposure was performed using an i-line stepper NSR-2205i11D (manufactured by Nikon Corporation) to form a square island pattern on the obtained photosensitive resin film via a mask in such a manner as to achieve a pitch width of 1:1 between adjacent patterns. After irradiation, spray development was performed with PGMEA for 20 seconds to form a pattern. After that, the formed 50-µm, 20-µm, 10-µm, 5-µm, and 3-µm square island patterns were observed with a scanning electron microscope (SEM), and the minimum pattern size at which adjacent island patterns (pitch width: 1:1) were not joined was obtained as the threshold resolution. In addition, the verticality of the patterns was evaluated, and a vertical pattern was evaluated as "Good", and a tapered shape or opening failure was evaluated as "Bad". The results are shown in Tables 7 to 12. In addition, when an agglomerated product of 0.5 µm or more was found on the formed pattern, the evaluation "Bad" was given, and when such products were not found, the evaluation "Good" was given. The results are shown in Tables 7 to 12.

### [4] Remaining Rate of Quantum Dots in Pattern after Development and after Solvent Resistance Test

Using a glass wafer as a substrate, a 4-cm square island pattern was formed by the same method as described above. In this event, regarding the films in the state after the exposure and in the state after the development, the absorbance of light having a wavelength of 460 nm was respectively measured using a spectrophotometer U-3900H (manufactured by Hitachi High-Tech Corporation). The absorbance is in proportion to the amount of remaining quantum dots, and therefore, it is possible to calculate from (absorbance after development)/(absorbance after exposure) the remaining rate of the quantum dots that were not eliminated during the development and remained. In addition, the sample after pattern formation was immersed in PGMEA for one hour, then, absorbance was measured again, and the remaining rate of the quantum dots was calculated by (absorbance after solvent resistance test)/(absorbance after exposure). The results are shown in Tables 7 to 12.

### [5] Luminous Property and Light Resistance Test for Cured Film

Photosensitive dry films with a protective film were prepared in the same manner as above so that the photosensitive resin film had a thickness of 30 µm, and the protective film was peeled. After that, using a mask aligner MA8 of SUSS MicroTec K.K. without an interposed mask, light was applied using a high-pressure mercury lamp (wavelength: 360 nm) as a light source, and then the base material film was peeled. Thus, a cured film was prepared. After that, using a quantum efficiency measurement system (QE-2100 manufactured by Otsuka Electronics Co., Ltd.), luminous properties, such as quantum yield, maximum fluorescence wavelength, and half band width were measured with the excitation wavelength set to 460 nm. Furthermore, after that, using Atlas SUNTEST XLS+, manufactured by Toyo Seiki Seisaku-sho, Ltd., a sunlight light resistance test was performed for 500 hours under conditions of illuminance of 65 W/m² and an environmental temperature of 100°C, the quantum yield was measured again, and the change rate between before and after the light resistance test was determined. The results are shown in Tables 7 to 12.

**[Table 7]**

| | | Example | | | | | | |
|---|---|---|---|---|---|---|---|---|
| | | R1 | R2 | R3 | R4 | R5 | R6 | R7 |
| Dry film cover film peeling property | | Good | Good | Good | Good | Good | Good | Good |
| Pattern | Threshold resolution/µm | 3 | 3 | 3 | 3 | 3 | 3 | 3 |
| | Shape | Good | Good | Good | Good | Good | Good | Good |
| | Agglomerated product | Good | Good | Good | Good | Good | Good | Good |
| Remaining rate of quantum dots | After development | 1.00 | 1.00 | 1.00 | 1.00 | 1.00 | 1.00 | 1.00 |
| | After chemical resistance test | 1.00 | 1.00 | 1.00 | 1.00 | 0.99 | 0.99 | 0.99 |
| Luminous properties | Maximum fluorescence wavelength/nm | 633 | 635 | 632 | 634 | 634 | 636 | 633 |
| | Half band width/nm | 33 | 34 | 33 | 35 | 33 | 35 | 33 |
| | Quantum yield/% | 85 | 86 | 83 | 86 | 87 | 83 | 75 |
| Change rate in quantum yield after light resistance test/% | | 0 | 0 | 0 | 0 | 0 | 0 | -2 |

**[Table 8]**

| | | Comparative Example | | | | | | | |
|---|---|---|---|---|---|---|---|---|---|
| | | R1 | R2 | R3 | R4 | R5 | R6 | R7 | R8 |
| Dry film cover film peeling property | | Bad | Bad | Bad | Bad | Bad | Bad | Bad | Bad |
| Pattern | Threshold resolution /µm | 10 | 10 | 20 | 20 | 20 | 10 | 20 | 10 |
| | Shape | Bad | Bad | Bad | Bad | Bad | Bad | Bad | Bad |
| | Agglomerated product | Bad | Bad | Bad | Bad | Bad | Bad | Bad | Bad |
| Remaining rate of quantum dots | After development | 0.84 | 0.85 | 0.72 | 0.73 | 0.74 | 0.83 | 0.75 | 0.83 |
| | After chemical resistance test | 0.79 | 0.79 | 0.69 | 0.70 | 0.70 | 0.75 | 0.71 | 0.76 |
| Luminous properties | Maximum fluorescence wavelength /nm | 646 | 647 | 648 | 646 | 649 | 648 | 648 | 647 |
| | Half band width/nm | 43 | 44 | 43 | 45 | 43 | 44 | 44 | 45 |
| | Quantum yield/% | 42 | 45 | 44 | 47 | 42 | 43 | 44 | 46 |
| Change rate in quantum yield after light resistance test/% | | -72 | -68 | -32 | -35 | -33 | -58 | -62 | -67 |

**[Table 9]**

| | | Comparative Example | | | | | |
|---|---|---|---|---|---|---|---|
| | | R9 | R10 | R11 | R12 | R13 | R14 |
| Dry film cover film peeling property | | Good | Good | Good | Good | Good | Good |
| Pattern | Threshold resolution /µm | 20 | 20 | 50 | 50 | 20 | 50 |
| | Shape | Bad | Bad | Bad | Bad | Bad | Bad |
| | Agglomerated product | Bad | Bad | Bad | Bad | Bad | Bad |
| Remaining rate of quantum dots | After development | 0.76 | 0.77 | 0.80 | 0.81 | 0.79 | 0.80 |
| | After chemical resistance test | 0.71 | 0.71 | 0.73 | 0.75 | 0.72 | 0.73 |
| Luminous properties | Maximum fluorescence wavelength /nm | 649 | 648 | 647 | 648 | 646 | 647 |
| | Half band width/nm | 43 | 44 | 43 | 45 | 44 | 43 |
| | Quantum yield/% | 38 | 35 | 36 | 35 | 36 | 37 |
| Change rate in quantum yield after light resistance test/% | | -72 | -73 | -69 | -70 | -59 | -61 |

**[Table 10]**

| | | Example | | | | | | |
|---|---|---|---|---|---|---|---|---|
| | | G1 | G2 | G3 | G4 | G5 | G6 | G7 |
| Dry film cover film peeling property | | Good | Good | Good | Good | Good | Good | Good |
| Pattern | Threshold resolution /µm | 3 | 3 | 3 | 3 | 3 | 3 | 3 |
| | Shape | Good | Good | Good | Good | Good | Good | Good |
| | Agglomerated product | Good | Good | Good | Good | Good | Good | Good |
| Remaining rate of quantum dots | After development | 1.00 | 1.00 | 1.00 | 1.00 | 1.00 | 1.00 | 1.00 |
| | After chemical resistance test | 1.00 | 1.00 | 1.00 | 1.00 | 0.99 | 0.99 | 0.99 |
| Luminous properties | Maximum fluorescence wavelength /nm | 525 | 535 | 526 | 536 | 524 | 534 | 525 |
| | Half band width/nm | 35 | 36 | 35 | 37 | 35 | 37 | 35 |
| | Quantum yield/% | 85 | 87 | 83 | 87 | 86 | 84 | 76 |
| Change rate in quantum yield after light resistance test/% | | 0 | 0 | 0 | 0 | 0 | 0 | -2 |

**[Table 11]**

| | | Comparative Example | | | | | | | |
|---|---|---|---|---|---|---|---|---|---|
| | | G1 | G2 | G3 | G4 | G5 | G6 | G7 | G8 |
| Dry film cover film peeling property | | Bad | Bad | Bad | Bad | Bad | Bad | Bad | Bad |
| Pattern | Threshold resolution /µm | 10 | 10 | 20 | 20 | 20 | 10 | 20 | 10 |
| | Shape | Bad | Bad | Bad | Bad | Bad | Bad | Bad | Bad |
| | Agglomerated product | Bad | Bad | Bad | Bad | Bad | Bad | Bad | Bad |
| Remaining rate of quantum dots | After development | 0.73 | 0.86 | 0.73 | 0.72 | 0.74 | 0.82 | 0.75 | 0.82 |
| | After chemical resistance test | 0.78 | 0.80 | 0.70 | 0.69 | 0.70 | 0.76 | 0.72 | 0.76 |
| Luminous properties | Maximum fluorescence wavelength /nm | 536 | 546 | 537 | 545 | 536 | 545 | 537 | 546 |
| | Half band width/nm | 45 | 46 | 45 | 47 | 45 | 46 | 46 | 47 |
| | Quantum yield/% | 43 | 44 | 46 | 45 | 43 | 42 | 45 | 45 |
| Change rate in quantum yield after light resistance test/% | | -70 | -66 | -31 | -32 | -35 | -59 | -61 | -65 |

**[Table 12]**

| | | Comparative Example | | | | | |
|---|---|---|---|---|---|---|---|
| | | G9 | G10 | G11 | G12 | G13 | G14 |
| Dry film cover film peeling property | | Good | Good | Good | Good | Good | Good |
| Pattern | Threshold resolution /µm | 20 | 20 | 50 | 50 | 20 | 50 |
| | Shape | Bad | Bad | Bad | Bad | Bad | Bad |
| | Agglomerated product | Bad | Bad | Bad | Bad | Bad | Bad |
| Remaining rate of quantum dots | After development | 0.77 | 0.76 | 0.81 | 0.82 | 0.80 | 0.79 |
| | After chemical resistance test | 0.72 | 0.71 | 0.74 | 0.75 | 0.73 | 0.73 |
| Luminous properties | Maximum fluorescence wavelength /nm | 536 | 536 | 546 | 547 | 537 | 547 |
| | Half band width/nm | 45 | 46 | 45 | 47 | 46 | 45 |
| | Quantum yield/% | 37 | 36 | 35 | 35 | 36 | 37 |
| Change rate in quantum yield after light resistance test/% | | -69 | -72 | -70 | -69 | -59 | -60 |

As shown in Tables 7 to 12, regarding Examples R1 to R7 and G1 to G7, being inventive photosensitive resin compositions, the photosensitive resin film was successfully peeled from the protective film, it was possible to form a vertical pattern with high resolution and moreover, there were no agglomerated products on the formed pattern, there was little elimination of quantum dots after the development and solvent resistance test, and luminous properties were also favorable and sustainable. On the other hand, regarding Comparative Examples R1 to R14 and G1 to G14, being photosensitive resin compositions missing one or more of the acrylic resin (A) having a (meth)acryloyl group in a side chain, the thiol ligand (B2), and the oxime-based photo-radical generator (C), pattern formation, the remaining rate of quantum dots, and luminous properties were all poor. In addition, regarding Comparative Examples R1 to R8 and G1 to G8, peeling property from the protective film was also poor.

From the above results, it was shown that the inventive photosensitive resin composition can form a favorable photosensitive film and a favorable photosensitive dry film, has high lithography properties of rectangularity and resolution, causes no agglomerated products (or if there are any, very small ones) in the formed pattern, has a high remaining rate of quantum dots in the pattern after development or after a solvent resistance test, and the cured film has high luminous properties and has favorable reliability (low change rate of emission intensity in the sunlight light resistance test). Therefore, the inventive photosensitive resin composition can provide a material suitable for a display (especially a micro-LED display).

The present description includes the following inventions.
[1]: A photosensitive resin composition comprising:
   (A) an acrylic resin having a (meth)acryloyl group in a side chain;
   (B1) quantum dots;
   (B2) a thiol ligand coordinated to a surface of the component (B1), the thiol ligand having a polymer structure including at least one repeating unit selected from ethylene oxide and propylene oxide;
   (C) an oxime-based photo-radical generator;
   (D) a surfactant; and
   (E) a solvent.
[2]: The photosensitive resin composition according to [1], wherein the component (A) is an alkali-insoluble resin having a weight-average molecular weight Mw of 10,000 to 50,000, a double bond equivalent of ≤ 300 g/mol, and an acid value of ≤ 10 mg KOH/g.
[3]: The photosensitive resin composition according to [1] or [2], wherein the component (B1) has a core-shell structure including a core and a shell covering the core, the core containing one or more compounds including a combination of two or more of In, P, Zn, Ga, Cd, Se, S, Te, Pb, Ag, Hg, N, As, and O, and the shell containing one or more compounds including a combination of two or more of In, P, Zn, Ga, Cd, Se, S, Te, Pb, Hg, N, As, O, Mn, and Sr.
[4]: The photosensitive resin composition according to any one of [1] to [3], wherein the component (B1) is contained in an amount of 10 to 50 mass% based on a non-volatile component of the photosensitive resin composition.
[5]: The photosensitive resin composition according to any one of [1] to [4], wherein the component (B2) is contained in an amount of 5 to 45 parts by mass based on 100 parts by mass of the component (B1).
[6]: The photosensitive resin composition according to any one of [1] to [5], wherein the component (C) is contained in an amount of 0.1 to 1.5 mass% based on a non-volatile component of the photosensitive resin composition.
[7]: A photosensitive resin film comprising a dried product of the photosensitive resin composition according to any one of [1] to [6].
[8]: A photosensitive dry film comprising: a support film; and the photosensitive resin film according to [7] on the support film.
[9]: A patterning process comprising the steps of:
   (i) applying the photosensitive resin composition according to any one of [1] to [6] onto a substrate to form a photosensitive resin film on the substrate;
   (ii) exposing the photosensitive resin film to light; and
   (iii) developing the exposed photosensitive resin film with a developer to dissolve and remove an unexposed portion for patterning.
[10]: The patterning process according to [9], wherein post-baking is not performed after the step (ii).
[11]: A patterning process comprising the steps of:
   (i') bonding the photosensitive resin film of the photosensitive dry film according to [8] to a substrate to form the photosensitive resin film on the substrate;
   (ii') exposing the photosensitive resin film to light; and
   (iii') developing the exposed photosensitive resin film with a developer to dissolve and remove an unexposed portion for patterning.
[12]: The patterning process according to [11], wherein post-baking is not performed after the step (ii').
[13]: A display comprising a pattern formed of a cured film of the photosensitive resin composition according to any one of [1] to [6].
[14]: A display comprising, in a top portion of a blue LED, a pattern formed of a cured film of the photosensitive resin composition according to any one of [1] to [6], light color-converted by quantum dots being obtained from each subpixel.
[15]: A micro-LED display comprising, in a top portion of a blue LED, a pattern formed of a cured film of the photosensitive resin composition according to any one of [1] to [6], the pattern formed of the cured film having a size of 0.01 mm² or less, and light color-converted by quantum dots being obtained from each subpixel.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A photosensitive resin composition comprising:
(A) an acrylic resin having a (meth)acryloyl group in a side chain;
(B1) quantum dots;
(B2) a thiol ligand coordinated to a surface of the component (B1), the thiol ligand having a polymer structure including at least one repeating unit selected from ethylene oxide and propylene oxide;
(C) an oxime-based photo-radical generator;
(D) a surfactant; and
(E) a solvent.

2. The photosensitive resin composition according to claim 1, wherein the component (A) is an alkali-insoluble resin having a weight-average molecular weight Mw of 10,000 to 50,000, a double bond equivalent of ≤ 300 g/mol, and an acid value of ≤ 10 mg KOH/g.

3. The photosensitive resin composition according to claim 1, wherein the component (B1) has a core-shell structure including a core and a shell covering the core, the core containing one or more compounds including a combination of two or more of In, P, Zn, Ga, Cd, Se, S, Te, Pb, Ag, Hg, N, As, and O, and the shell containing one or more compounds including a combination of two or more of In, P, Zn, Ga, Cd, Se, S, Te, Pb, Hg, N, As, O, Mn, and Sr.

4. The photosensitive resin composition according to claim 1, wherein the component (B1) is contained in an amount of 10 to 50 mass% based on a non-volatile component of the photosensitive resin composition.

5. The photosensitive resin composition according to claim 1, wherein the component (B2) is contained in an amount of 5 to 45 parts by mass based on 100 parts by mass of the component (B1).

6. The photosensitive resin composition according to claim 1, wherein the component (C) is contained in an amount of 0.1 to 1.5 mass% based on a non-volatile component of the photosensitive resin composition.

7. A photosensitive resin film comprising a dried product of the photosensitive resin composition according to any one of claims 1 to 6.

8. A photosensitive dry film comprising: a support film; and the photosensitive resin film according to claim 7 on the support film.

9. A patterning process comprising the steps of:
(i) applying the photosensitive resin composition according to any one of claims 1 to 6 onto a substrate to form a photosensitive resin film on the substrate;
(ii) exposing the photosensitive resin film to light; and
(iii) developing the exposed photosensitive resin film with a developer to dissolve and remove an unexposed portion for patterning.

10. The patterning process according to claim 9, wherein post-baking is not performed after the step (ii).

11. A patterning process comprising the steps of:
(i') bonding the photosensitive resin film of the photosensitive dry film according to claim 8 to a substrate to form the photosensitive resin film on the substrate;
(ii') exposing the photosensitive resin film to light; and
(iii') developing the exposed photosensitive resin film with a developer to dissolve and remove an unexposed portion for patterning.

12. The patterning process according to claim 11, wherein post-baking is not performed after the step (ii').

13. A display comprising a pattern formed of a cured film of the photosensitive resin composition according to any one of claims 1 to 6.

14. A display comprising, in a top portion of a blue LED, a pattern formed of a cured film of the photosensitive resin composition according to any one of claims 1 to 6, light color-converted by quantum dots being obtained from each subpixel.

15. A micro-LED display comprising, in a top portion of a blue LED, a pattern formed of a cured film of the photosensitive resin composition according to any one of claims 1 to 6, the pattern formed of the cured film having a size of 0.01 mm² or less, and light color-converted by quantum dots being obtained from each subpixel.
